# EUROPEAN PATENT APPLICATION

(11) **EP 2 568 514 A2**
(43) Date of publication of application: **13.03.2013**
(21) Application number: 12164637.6
(22) Date of filing: 18.04.2012
(51) Int. Cl.: H01L 33/50, H01L 33/48, H01L 33/38

(54) **LED comprising wavelength conversion layer in the substrate**

(30) Priority: 08.09.2011 KR 20110091426
(71) Applicant: LG Innotek Co., Ltd., Seoul 100-714 (KR)
(72) Inventor: Lee, Yonggyeong, 100-714 Seoul (KR); Choi, Byungyeon, 100-714 Seoul (KR); Choung, Jaewoong, 100-714 Seoul (KR)
(74) Representative: Zardi, Marco

(57) **Abstract**

Embodiments provide a light emitting device (10) comprising a support member (1) and a light emitting structure (6) disposed on the support member (1), the light emitting structure (6) comprising a first semiconductor layer (3) having first and second regions (s1, s2), a second semiconductor layer (5) disposed on the second region (s2), and an active layer (4) between the first and second semiconductor layers (3, 5), wherein the support member (1) includes metal ions (m1, m2) to convert light of a first wavelength emitted from the active layer (4) into light of a second wavelength different from the first wavelength.

## Description

### CROSS-REFERENCE TO RELATED APPLICATION

This application claims the priority benefit of Korean Patent Application No. 10-2011-0091426, filed on September 08, 2011 in the Korean Intellectual Property Office, the disclosure of which is incorporated herein by reference.

### BACKGROUND

### 1. Field

Embodiments relate to a light emitting device.

### 2. Description of the Related Art

Generally, a light emitting diode (LED) as a light emitting device is a semiconductor device, which emits light in accordance with recombination of electrons and holes. Such an LED is widely used as a light source in optical communications, electronic appliances, etc.

The frequency (or wavelength) of light emitted from an LED is a function of the band gap of a material used in the LED. When a semiconductor material having a narrow band gap is used, low energy and thus long wavelength photons are generated. On the other hand, when a semiconductor material having a wide band gap is used, high energy and thus short wavelength photons are generated.

For example, an AlGaInP material generates light of a red wavelength. On the other hand, a silicon carbide (SiC) material or a Group-III nitride-based semiconductor, in particular, a GaN material generates light of a blue or ultraviolet wavelength.

Recently, light emitting devices are required to have high luminance so as to be used as light sources for illumination. In order to achieve such high luminance, research into manufacture of a light emitting device capable of achieving uniform current diffusion, and thus, enhancement in light emission efficiency, is being conducted.

### SUMMARY

Embodiments provide a light emitting device comprising a support member and a light emitting structure disposed on the support member, the light emitting structure comprising a first semiconductor layer comprises a first and second regions, a second semiconductor layer disposed on the second region, and an active layer between the first and second semiconductor layers, wherein the support member includes metal ions to convert light of a first wavelength emitted from the active layer into light of a second wavelength different from the first wavelength.

The light emitting device according to the embodiments includes the metal ions in the support member thereof to convert light of a given wavelength emitted from the light emitting structure and incident upon the support member into light of a wavelength different from the given wavelength. Thus, as for the light emitting device assembled in the light emitting device package, the phosphor may be dispensed with or a very small amount of the phosphor may be contained, thereby reducing the manufacturing cost of the light emitting device package.

### BRIEF DESCRIPTION OF THE DRAWINGS

Details of the embodiments will be more clearly understood from the following detailed description taken in conjunction with the accompanying drawings, in which:
FIG. 1 is a perspective view of a light emitting device according to one embodiment;
FIG. 2 to FIG. 5 are perspective views of various embodiments of a second layer including metal ions of a support member in FIG. 1;
FIG. 6 is a perspective view of a light emitting device package according to one embodiment;
FIG. 7 is a perspective view of a first embodiment of first and second lead frames of FIG. 6;
FIG. 8 is a cross-sectional view illustrating a state in which a light emitting device is disposed on the first and second lead frames of FIG. 7;
FIG. 9 is a perspective view of a second embodiment of first and second lead frames of FIG. 6;
FIG. 10 is a cross-sectional view illustrating a state in which a light emitting device is disposed on the first and second lead frames of FIG. 9;
FIG. 11 is a perspective view of an illumination device including a light emitting device according to one embodiment;
FIG. 12 is a cross-sectional view taken at a line A-A' of the illumination device of FIG. 11;
FIG. 13 is a disassembled perspective view of a liquid crystal display device including a light emitting device according to one embodiment; and
FIG. 14 is a disassembled perspective view of a liquid crystal display device including a light emitting device according to another embodiment.

### DETAILED DESCRIPTION OF EMBODIMENTS

Reference will now be made in detail to embodiments, examples of which are illustrated in the accompanying drawings. However, the present disclosure may be embodied in many different forms and should not be construed as limited to the embodiments set forth herein. Rather, these embodiments are provided so that this disclosure will be thorough and complete, and will fully convey the scope of the disclosure to those skilled in the art. The present disclosure is defined only by the categories of the claims. In certain embodiments, detailed descriptions of device constructions or processes well known in the art may be omitted to avoid obscuring appreciation of the disclosure by a person of ordinary skill in the art. Wherever possible, the same reference numbers will be used throughout the drawings to refer to the same or like parts.

Spatially-relative terms such as "below", "beneath", "lower", "above", or "upper" may be used herein to describe one element's relationship to another element as illustrated in the figures. It will be understood that spatially-relative terms are intended to encompass different orientations of the device in addition to the orientation depicted in the figures. For example, if the device in one of the figures is turned over, elements described as "below" or "beneath" other elements would then be oriented "above" the other elements. The exemplary terms "below" or "beneath" can, therefore, encompass both an orientation of above and below. Since the device may be oriented in another direction, the spatially-relative terms may be interpreted in accordance with the orientation of the device.

The terminology used in the present disclosure is for the purpose of describing particular embodiments only and is not intended to limit the disclosure. As used in the disclosure and the appended claims, the singular forms "a", "an" and "the" are intended to include the plural forms as well, unless context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

In the drawings, the thickness or size of each layer is exaggerated, omitted, or schematically illustrated for convenience of description and clarity. Also, the size or area of each constituent element does not entirely reflect the actual size thereof.

When describing a configuration of a light emitting device in exemplary embodiments, angles and/or directions may be based on associated drawings. Unless a reference point with regard to angles and/or positional relationships are clearly expressed herein when describing a configuration of a light emitting device in exemplary embodiments, the reference point and/or positional relationships may be based on associated drawings.

Hereinafter, embodiments will be described in detail with reference to the drawings.

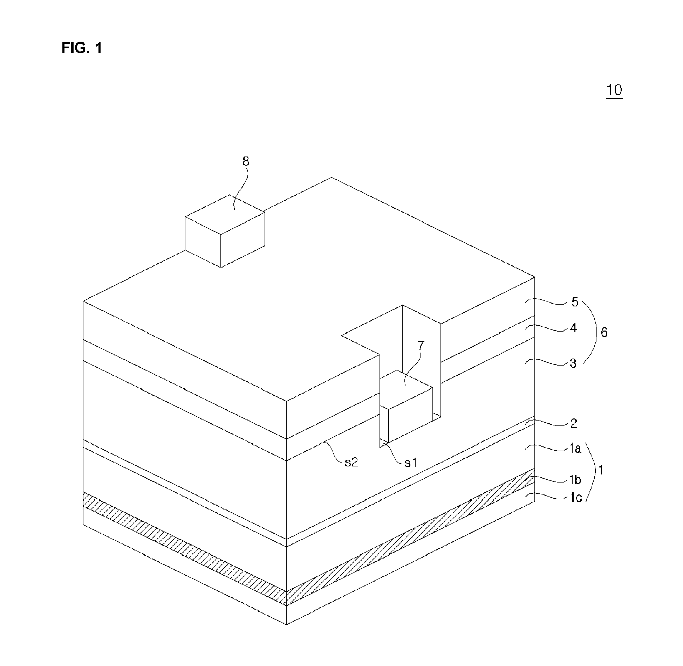

FIG. 1 is a perspective view of a light emitting device according to one embodiment of the invention.

Referring to FIG. 1, a light emitting device 10 includes a support member 1 and a light emitting structure 6 disposed over the support member 1.

The support member 1 may be made of a conductive or insulating substrate. For example, the support member 1 may be made of at least one of Al₂O₃, SiC, Si, GaAs, GaN, ZnO, Si, GaP, InP, Ge, and Ga₂0₃.

In this embodiment, the support member 1 is made of Al₂O₃. The present disclosure is not limited thereto.

The support member 1 may be subjected to a wet cleaning process so that impurities on a surface thereof are removed. The support member 1 may have a light-extraction pattern (not shown) formed at a surface thereof so as to enhance light extraction efficiency. The present disclosure is not limited thereto.

The support member 1 may include a material to facilitate heat discharge and thus allow the support member 1 to have improved thermal stability.

The support member 1 may include an anti-reflection layer (not shown) formed thereon called "an AR (anti-reflective) coating layer". The anti-reflection layer basically utilizes interference between light beams reflected from a plurality of interfaces. That is, the anti-reflection layer functions to shift the phases of light beams reflected from different interfaces such that differences between the phases of the reflected light beams are 180°, thus allowing the reflected light beams to be offset from each other and thereby reducing the intensity of the reflected light. The present disclosure is not limited thereto.

The support member 1 may convert a first light beam of a first wavelength emitted from the light emitting structure 6 into a second light beam of a second wavelength different from the first wavelength. The support member 1 may include a first layer 1 a adjacent to the light emitting structure 6, a second layer 1 b adjacent to the first layer 1 a and capable to convert the first light beam into the second light beam, and a third layer 1c adjacent to the second layer 1 b.

Each of the first and third layers 1 a and 1c may be made of an Al₂O₃ substrate layer to transmit the first light beam and the second layer 1b may include metal ions (not shown) to convert the first light beam into the second light beam.

The metal ions may include, for example, at least one of vanadium ions, chromium ions, titanium ions, and iron ions. The metal ions may include different metal ions from the above metal ions. The present disclosure is not limited thereto.

A ratio of the metal ions to an aluminum (Al) contained in an Al₂O₃ of the support member 1 may be in a range of 0.01 % to 0.1 %.

When the ratio is below 0.01 %, the first light beam may be converted into the second light beam at a lower rate. When the ratio is above 0.1 %, the manufacturing costs of the light emitting device may increase and, in addition, a first color of the first light beam may be converted to a second color of the second light beam more concentrated than the first color.

The second layer 1 b may be made of an Al₂O₃ substrate containing the metal ions implanted thereto using an ion implantation method. A location of the second layer 1b may vary depending on at least one of heat and energy for implanting the metal ions using an ion implant device (not shown). The present disclosure is not limited thereto.

In this embodiment, the second layer 1b is formed to be interposed between the first and third layers 1a and 1c, although the support member 1 may consist of the second layer 1 b alone or may consist of the first and second layers 1 a and 1 b without the third layer 1 c.

For example, when the second layer 1b is an Al₂O₃ substrate and chromium ions are implanted thereto, the second light beam exhibits a red color. When the second layer 1 b is an Al₂O₃ substrate and vanadium ions are implanted thereto, the second light beam exhibits a purple color. When the second layer 1 b is an Al₂O₃ substrate and iron ions are implanted thereto, the second light beam exhibits a yellowish green color being a mixture of yellow and green colors.

For example, when the ratio of the chromium ions is below 0.01 %, the second light beam exhibits a pink color less concentrated than the red color. On the other hand, when the ratio of the chromium ions is above 0.1 %, the second light beam exhibits a red color more concentrated than the red color of the first light beam.

A thickness of the second layer 1 b may be equal to or less than that of the support member 1, although the present disclosure is not limited thereto.

Between the support member 1 and the light emitting structure 6, there may be disposed a buffer layer 2 to reduce lattice mismatch between the member 1 and structure 6 and thus to allow a plurality of semiconductor layers to be reliably grown on the support member 1.

The buffer layer 2 may be a single-crystal layer grown on the support member 1. The single-crystal buffer layer 2 may improve crystallinity of the light emitting structure 6 grown thereon.

The buffer layer 2 may be formed as a stacked structure including AIN and/or GaN materials. For example, the stacked structure may include an AIInN/GaN structure, an InGaN/GaN structure, or an AIInGaN/InGaN/GaN structure, or the like.

A first semiconductor layer 3 of the light emitting structure 6 is formed on the support member 1 or the buffer layer 2. When the first semiconductor layer 3 is realized as an N type semiconductor layer, the layer 3 may be made of a semiconductor material having, for example, a composition of InₓAlyGa₁₋ₓ₋yN (0≤x≤1, 0≤y≤1, and 0≤x+y≤1) such as gallium nitride (GaN), aluminum nitride (AIN), aluminum gallium nitride (AIGaN), indium gallium nitride (InGaN), indium nitride (InN), indium aluminum gallium nitride (InAlGaN), aluminum indium nitride (AlInN) or the like which is doped with an N type dopant such as silicon (Si), germanium (Ge), tin (Sn), selenium (Se), tellurium (Te), etc.

The first semiconductor layer 3 is divided into first and second regions s1 and s2. In the second region s2, there is disposed, on the first semiconductor layer 3, an active layer 4 formed to have a single or multiple quantum well structure, a quantum-wire structure, a quantum dot structure or the like using a Group III - Group V compound semiconductor material.

When the active layer 4 has the quantum well structure, the quantum well structure may be a single or multiple quantum well structure including a well layer having a composition of InₓAl_{y}Ga_{1-x-y}N (0≤x≤1, 0≤y≤1, and 0≤x+y≤1) and a barrier layer having a composition of InₐAl_{b}Ga_{1-a-b}N (0≤a≤1, 0≤b≤1, and 0≤a+b≤1). The well layer may be made of a material having a smaller energy band gap than that of the barrier layer.

If the active layer 4 has a multiple quantum well structure, the respective well layers (not shown) and the respective barrier layers (not shown) may have different compositions, thicknesses and band gaps, although the disclosure is not limited thereto.

And an energy band gab of the well layer or barrier layer adjacent to the second semiconductor layer 5 has is larger than an energy band gap of the well layer or barrier layer adjacent to the first semiconductor layer 3.

On and/or beneath the active layer 4, there may be disposed an electrically conductive cladding layer (not shown) made of an AIGaN based semiconductor material and having a larger energy band gap than that of the active layer 4.

In the second region s2, there is disposed, on the active layer 4, a second semiconductor layer 5 which is realized as the P type semiconductor layer made of a semiconductor material having a composition of InₓAlyGa₁₋ₓ₋yN (0≤x≤1, 0≤y≤1, and 0≤x+y≤1), such as gallium nitride (GaN), aluminum nitride (AIN), aluminum gallium nitride (AIGaN), indium gallium nitride (InGaN), indium nitride (InN), indium aluminum gallium nitride (InAlGaN), aluminum indium nitride (AlInN) or the like which is doped with a P type dopant such as magnesium (Mg), zinc (Zn), calcium (Ca), strontium (Sr), carbon (C), barium (Ba) or the like.

The first semiconductor layer 3, the active layer 4 and the second semiconductor layer 5 may be formed using MOCVD (metal organic chemical vapor deposition), CVD (chemical vapor deposition), PECVD (plasma enhanced CVD), MBE (molecular beam epitaxy) or HVPE (hydride vapor phase epitaxy), etc. The present disclosure is not limited thereto.

A doping concentration of the N type and/or P type dopant in the first and/or second semiconductor layers 3 and 5 may be uniform or non-uniform. That is, a configuration of the semiconductor layers may be various. The present disclosure is not limited thereto.

Unlike the above-illustrated example, the first and second semiconductor layers 3 and 5 may be realized as P type and N type semiconductor layers respectively. In addition, an additional semiconductor layer may be formed thereon. Accordingly, the light emitting structure 6 may include at least one of an N-P junction, a P-N junction, an N-P-N junction, and a P-N-P junction.

In this embodiment, after the first semiconductor layer 3, the active layer 4 and the second semiconductor layer 5 are formed, a mesa-etching is carried so that the first semiconductor layer 3 is exposed in the first region s1.

Then, in the first region s1, there is formed, on the first semiconductor layer 3, a first electrode 7 in electrical contact therewith. A second electrode 8 is formed on the second semiconductor layer 5 to be in electrical contact therewith at an opposite side to the first electrode 7.

At lease one of the first and second electrodes 7 and 8 may be made of at least one of cobalt (Co), copper (Cu), niobium (Nb), tin (Sn), indium (In), scandium (Sc), tantalum (Ta), vanadium (V), platinum (Pt), silicon (Si), silver (Ag), gold (Au), zinc (Zn), antimony (Sb), aluminum (A1), germanium (Ge), hafnium (Hf), lanthanum (La), magnesium (Mg), manganese (Mn), nickel (Ni), palladium (Pd), rhenium (Re), tungsten (W), ruthenium (Ru), molybdenum (Mo), iridium (Ir), rhodium (Rh), tantalum (Ta), zirconium (Zr) and titanium (Ti) or an alloy thereof. The present disclosure is not limited thereto.

At lease one of the first and second electrodes 7 and 8 may have a single layer structure or a multi-layer structure. The present disclosure is not limited thereto.

At least one of a light-transmissive electrode layer (not shown), a reflective electrode layer (not shown) and a wavelength conversion layer (not shown) may be formed between the light emitting structure 6 and the second electrode 8, and/or between the first semiconductor layer 3 and the first electrode 7. The present disclosure is not limited thereto.

The light-transmissive electrode layer may be electrically conductive and light-transmissive and uniformly diffuse electrical current applied from the second electrode 8 to the second semiconductor layer 5 therethrough, thereby preventing current concentration at a location beneath the second electrode 8.

The light-transmissive electrode layer includes at lease one of ITO, IZO(In-ZnO), GZO(Ga-ZnO), AZO(AI-ZnO), AGZO(AI-Ga ZnO), IGZO(In-Ga ZnO), IrOx, RuOx, RuOx/ITO, Ni/IrOx/Au and Ni/IrOx/Au/ITO.

The wavelength conversion layer may be disposed on the second semiconductor layer 5 or the light-transmissive electrode layer and include a phosphor to convert or excite light emitted from the light emitting structure 6 into light of the same wavelength as that of the second light beam resulting from the conversion by the metal ions.

The wavelength conversion layer may be a coating film over the second semiconductor layer 5 or the light-transmissive electrode layer or may be a film containing the phosphor. The present disclosure is not limited thereto.

The reflective electrode layer may be made of at least one of aluminum (AI), silver (Ag) and copper (Cu). In case the light emitting device 10 is of a flip-chip type or a horizontal type, light beams emitted from the light emitting structure 6 advantageously have the same wavelength using the reflective electrode layer and the wavelength conversion layer.

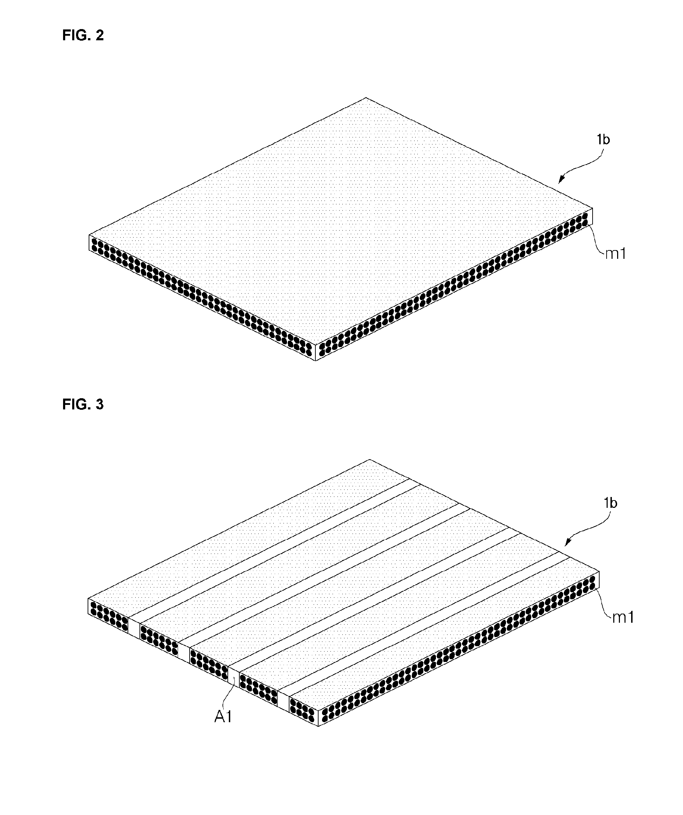

FIG. 2 to FIG. 5 are perspective views of various embodiments of the second layer including the metal ions of the support member in FIG. 1.

In FIG. 2 to FIG. 5, the same elements are designated as the same reference numerals. Although the metal ions are shown as uniformly distributed in the rectangular second layer 1b in FIG. 2 to FIG. 5, the metal ions may be non-uniformly distributed in the support member 1. The metal ions may be distributed in at least one of the first and third layers 1 a and 1c. The present disclosure is not limited thereto.

First, a second layer 1 b as shown In FIG. 2 may include the same kind of first metal ions m1.

The first metal ions m1 may be disposed between the first and third layers 1a and 1c. Further, the first metal ions m1 may be disposed in at least one of the first and third layers 1 a and 1 c. The present disclosure is not limited thereto.

The first metal ions m1 may convert first light beams of a first wavelength emitted from the light emitting structure 6 into second light beams of a second wavelength different from the first wavelength, thereby enabling light incident upon the support member 1 to exhibit a particular color including a white.

A second layer 1 b as shown in FIG. 3 may be patterned and include first metal ions m1.

The second layer 1b is patterned such that light beams emitted therefrom include first light beams of a first wavelength emitted from the light emitting structure 6 and second light beams of a second wavelength different from the first wavelength.

That is, the support member 1 may emit the first light beams passing through the first, second and third layers 1a, 1b and 1c without any change and the second light beams resulting from the conversion by the metal ions m1 of the second layer 1 b, thereby rendering at least two colors.

To this end, the second layer 1b includes first stripe-shape patterned regions including the implanted metal ions m1 and second stripe-shape patterned regions A1 between the first stripe-shape patterned regions without the metal ions. In the second stripe-shape patterned regions A1, the first light beams emitted from the light emitting structure 6 propagate the second layer 1b without any change. In the second stripe-shape patterned regions A1, the second layer 1b may be the same Al₂O₃ substrate as the first and third layers 1a and 1c. It is noted that the patterned shape is not limited to the stripe shape. Any other patterned shapes are possible.

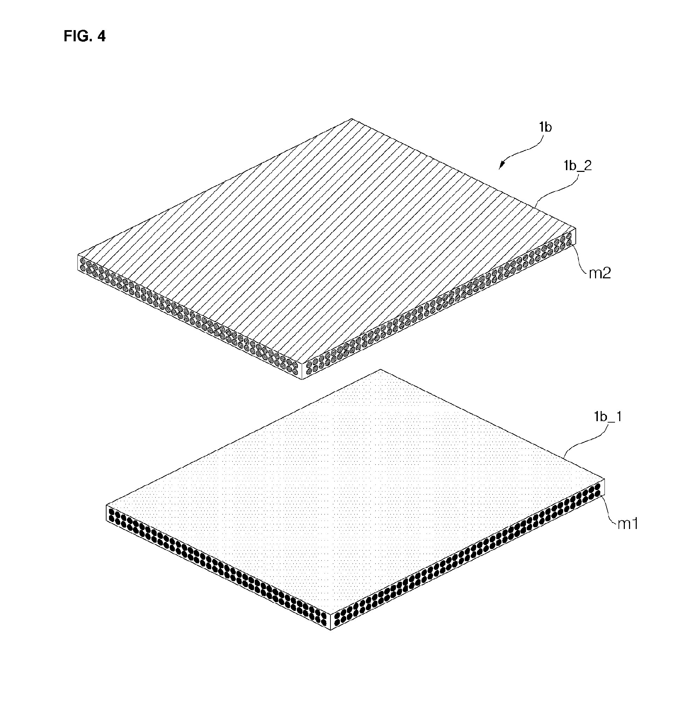

A second layer 1b shown in FIG. 4 may include a first layer 1b_1 including first metal ions m1 implanted therein and a second layer 1b_2 including second metal ions m2 implanted therein different from the first metal ions m1.

The first metal ions m1 may convert first light beams of a first wavelength emitted from the light emitting structure 6 into second light beams of a second wavelength different from the first wavelength, while the second metal ions m2 may convert at least one of the first and second light beams into third light beams of a third wavelength different from the first and second wavelengths.

The first and second layers 1b_1 and 1b_2 may be formed depending on at least one of energy and heat for implanting the metal ions using an ion implantation device during an ion implant process.

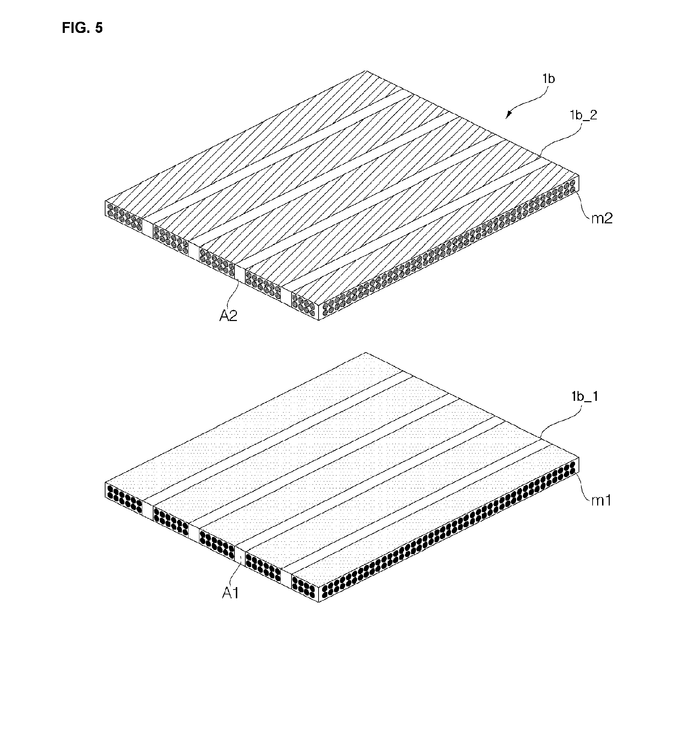

A second layer 1b shown in FIG. 5 may emit at least one of first light beams of a first wavelength emitted from the light emitting structure 6, second light beams of a second wavelength converted from the first light beams, third light beams of a third wavelength converted from at least one of the first and second light beams, and fourth light beams being a mixture of the second and third light beams.

To this end, the second layer 1b shown in FIG. 5 may include a first layer 1b_1 including first stripe-shape patterned regions A1 without any metal ions to transmit the first light beams and second stripe-shape patterned regions between the first stripe-shape patterned regions A1 having first metal ions m1 to convert the first light beams; and a second layer 1b_2 including third stripe-shape patterned regions A2 without any metal ions corresponding to the first stripe-shape patterned regions A1 respectively and fourth stripe-shape patterned regions having second metal ions m2 corresponding to the second stripe-shape patterned regions respectively. It is noted that the patterned shape is not limited to the stripe shape. Any other patterned shapes are possible.

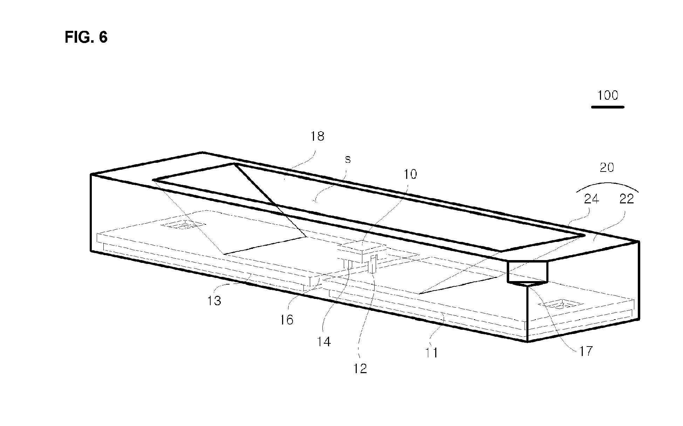

FIG. 6 is a perspective view of a light emitting device package according to one embodiment.

FIG. 6 is a perspective view illustrating a partial inner configuration of the light emitting device package 100 in a see-through manner. In this embodiment, the light emitting device package 100 is of a top-emitting type. However, the light emitting device package 100 may be of a side-emitting type. The present disclosure is not limited thereto.

Referring to FIG. 6, the light emitting device package 100 includes the light emitting device 10 and a body 20 to seat the light emitting device 10 therein.

The body 20 may include first body portions 22 extending in a first direction (now shown) and second body portions 24 extending in a second direction (now shown) perpendicular to the first direction. The first and second body portions 22 and 24 may be integrated with each other, and may be formed using an injection molding process or an etching process, etc. The present disclosure is not limited thereto.

The first and second body portions 22 and 24 may be made of at least one selected from among a resin such as polyphthalamide (PPA), silicon (Si), aluminum (AI), aluminum nitride (AIN), AlOₓ, a liquid crystal polymer such as photosensitive glass (PSG), polyamide 9T (PA9T), syndiotactic polystyrene (SPS), a metal, sapphire (Al₂O₃), beryllium oxide (BeO), ceramics, and a Printed Circuit Board (PCB).

The top shape of the body 20 may be triangular, rectangular, polygonal, circular, or the like depending on application and design of the light emitting device package 100.

The first and second body portions 22 and 24 form a cavity s to seat the light emitting device 10 therein. The cavity s may be formed to have a cross-section in a shape of a cup, concave vessel, etc. Each of the first and second body portions 22 and 24 forming the cavity s may have an inner side surface sloped relative to a bottom of the body 20.

A top view of the cavity s may have a circular, rectangular, polygonal or elliptical shape, etc. The present disclosure is not limited thereto.

First and second lead frames 11 and 13 may be disposed on an inner bottom face of the body 20. The first and second lead frames 11 and 13 may be made of an electrically conductive material such as a metal. For example, the lead frames 11 and 13 may be made of one or more selected from a group consisting of titanium (Ti), copper (Cu), nickel (Ni), gold (Au), chromium (Cr), tantalum (Ta), platinum (Pt), tin (Sn), silver (Ag), phosphorous (P), aluminum (AI), indium (In), palladium (Pd), cobalt (Co), silicon (Si), germanium (Ge), hafnium (Hf) ruthenium (Ru) and iron (Fe) and may include an alloy thereof.

The first and second lead frames 11 and 13 may be formed to have a single layer structure or a multi-layer structure. The present disclosure is not limited thereto.

The first and second lead frames 11 and 13 may respectively have first and second projections 12 and 14 formed thereon which is electrically connected to first and second electrodes (not shown) of the light emitting device 10 respectively.

Each of the first and second body portions 22 and 24 may have an inner side surface sloped relative to any one of the first and second lead frames 11 and 13 at a predetermined angle. Thus, the reflection angle of light emitted from the light emitting device 10 may be determined based on the slope angle of the inner side surfaces of the first and second body portions 22 and 24, thereby adjusting the orientation angle of light to be extracted to the outside. The smaller the orientation angle of light, the greater the convergence of light emitted from the light emitting device 10 to the outside. On the contrary, the greater the orientation angle of light, the smaller the convergence of light emitted from the light emitting device 10 to the outside.

A number of the inner sloped side surfaces may be formed in the body 20, although the present disclosure is not limited thereto.

The first and second lead frames 11 and 13 may be electrically connected to the first and second electrode and in turn be electrically connected to positive and negative electrodes or vice versa of an external power supply respectively, to supply electrical power to the light emitting device 10.

In this embodiment, the light emitting device 10 is of a flip chip type. The first and second electrodes having opposite polarities are bonded to the first and second projections 12 and 14 respectively.

Adhesive members (not shown) may be disposed respectively between the first projection 12 and the first electrode 7 in FIG. 2 and between the second projection 14 and the second electrode 8 in FIG. 2. This will be described later in detail.

An insulation dam 16 may be provided between the first and second lead frames 11 and 13 to prevent short circuit therebetween.

In this embodiment, the insulation dam has a flat upper surface, although the present disclosure is not limited thereto.

The body 20 may be provided with a cathode mark 17 which serves to identify polarities of the first and second lead frames 11 and 13, thereby preventing misconnection of the first and second lead frames 11 and 13 to the external power supply.

For example, the light emitting device 10 may be a light emitting diode. The light emitting diode may be, for example, a color light emitting diode emitting red, green, blue, white light, etc. or may be a UV light emitting diode emitting ultra-violet light. The present disclosure is not limited thereto. One or more light emitting devices 10 may be mounted on the lead frames. The number and/or arrangement of the light emitting device 10 are not limited to the particulars.

The body 20 may include a resin material 18 filling the cavity s. Specifically, the resin material 18 may have a dual molded structure or a triple molded structure, although the present disclosure is not limited thereto.

The resin material 18 may take the form of a film, and may contain at least one of a phosphor and a light diffusing agent. Alternatively, the resin material 18 may be made of a transparent material not containing the phosphor and the light diffusing agent, although the present disclosure is not limited thereto.

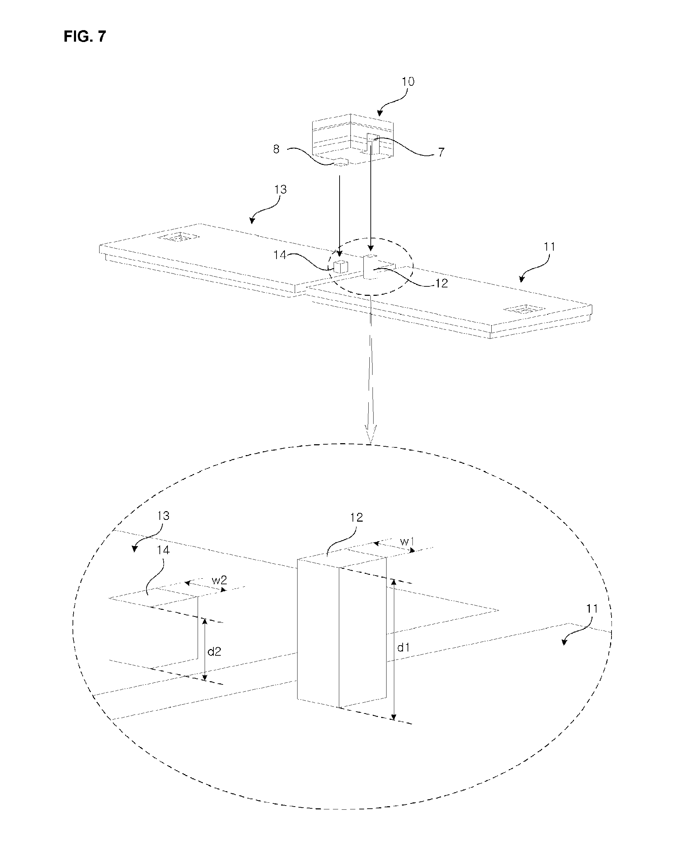

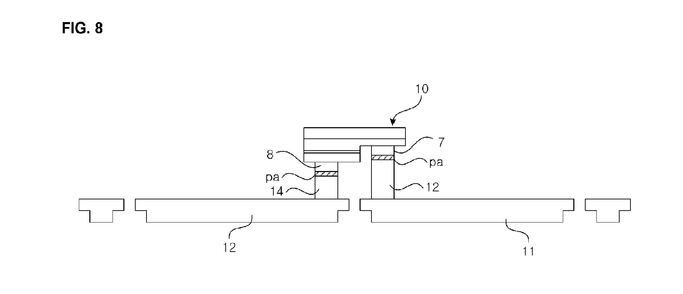

FIG. 7 is a perspective view of a first embodiment of the first and second lead frames of FIG. 6. FIG. 8 is a cross-sectional view illustrating a state in which a light emitting device is disposed on the first and second lead frames of FIG. 7.

Referring to FIG. 7 and 8, the first frame 11 has the first projection 12 formed therefrom which is electrically connected to the first electrode 7 of the light emitting device 10. The second frame 13 has the second projection 14 formed thereon which is electrically connected to the second electrode 8 of the light emitting device 10.

The first and second electrodes 7 and 8 of the light emitting device 10 may have the same thickness as each other as shown in FIG. 1. However, as the first and second electrodes 7 and 8 are disposed at different levels of the light emitting device 10, the first and second projections corresponding to the first and second electrodes 7 and 8 respectively have different dimensions.

The first projection 12 extends uprightly from an upper surface of the first lead frame 11 so as to have a first height d1 and a first upper portion width w1.

The second projection 14 extends uprightly from an upper surface of the second lead frame 13 so as to have a second height d2 and a second upper portion width w2.

In this embodiment, each of the first and second projections 12 and 14 is configured such that a lower portion thereof has the same width as an upper portion thereof. Alternatively, each of ratios of the first and second upper portions w1 and w2 respectively to first and second lower portion widths (not labeled) of the first and second projections 12 and 14 may be in a range of 0.2 to 1. The present disclosure is not limited thereto.

That is, the first and second upper portions w1 and w2 of at least one of the first and second projections 12 and 14 is 0.2 times to 1 times the first and second lower portion widths of the first and second projections 12 and 14.

Since the first and second lower portion widths of the first and second projections 12 and 14 are larger than the first and second upper portions w1 and w2 thereof respectively, the light emitting device 10 may be stably disposed thereon.

The first and second upper portions w1 and w2 of the first and second projections 12 and 14 may be equal to or larger than widths (not labeled) of the first and second electrodes 7 and 8. Thus, the light emitting device 10 may be stably disposed on the first and second projections 12 and 14.

Nevertheless, in order to prevent short circuit between the first upper portion of the first projection 12 and the active layer 4 and/or the second semiconductor layer 5 of the light emitting device 10, the first upper portion width w1 must be smaller that a width of the first region s1 of the first semiconductor layer 3.

Accordingly, a ratio of the second upper portion width w2 to the first upper portion width w1 may be in a range of 1 to 2.

That is, the first upper portion width w1 of the first projection 12 is 1 times to 2 times the second upper portion width w2 of the second projection 14.

Since, as mentioned above, the first and second electrodes 7 and 8 are disposed at different levels of the light emitting device 10, a ratio of the first height d1 to the second height d2 may be in a range of 1 to 5.

That is, the first height d1 of the first projection 12 is 1 times to 5 times the second height d2 of the second projection 14.

Nevertheless, as the second electrode 8 is disposed on the second semiconductor layer 5, the second upper portion width w2 may be equal to the first upper portion width w1. Otherwise, if the second upper portion width w2 is two or more times lager than the first upper portion width w1, light emission efficiency of the light emitting device 10 may be reduced.

If the ratio of the first height d1 to the second height d2 is smaller than 1, it is difficult for the first projection 12 to be electrically connected to the first electrode 7. On the other hand, if the ratio of the first height d1 to the second height d2 is larger than 5, a vertical length (not labeled) of the second electrode 8 should be larger, leading to a deterioration in electrical stability of the light emitting device 10.

The first and second projections 12 and 14 may be spaced substantially the same distance from a center between facing-away sides of the first and second lead frames 11 and 13. The first and second projections 12 and 14 may be disposed in a symmetrical relationship with each other. The present disclosure is not limited thereto.

Top shapes of the first and second projections 12 and 14 may respectively correspond to those of the first and second electrodes 7 and 8. The present disclosure is not limited thereto.

Adhesive members pa may be respectively disposed between the first projection 12 and the first electrode 7 and between the second projection 14 and the second electrode 8.

The adhesive members pa may respectively serve to electrically connect the first projection 12 to the first electrode 7 and the second projection 14 to the second electrode 8. To this end, each of the adhesive members pa may be formed of at least one of a bonding ball, an adhesive paste and an adhesive film containing at least one of silver (Ag) and gold (Au).

Since there are formed respective attachments between the first projection 12 and the first electrode 7 and between the second projection 14 and the second electrode 8 using the adhesive members pa, short circuit between the first electrode 7 and the second projection 14 and between the second electrode 8 and the first projection 12 may be advantageously prevented.

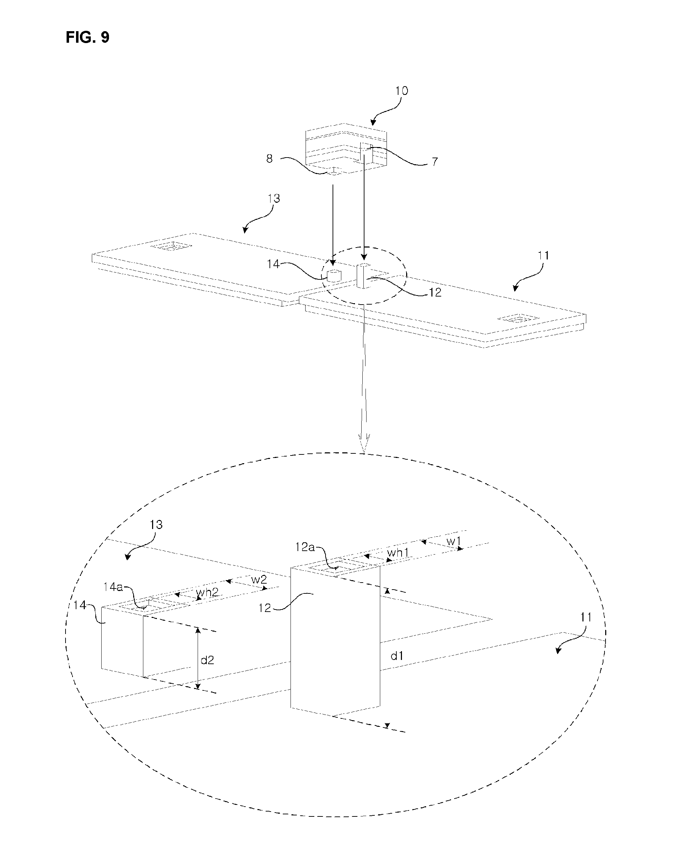

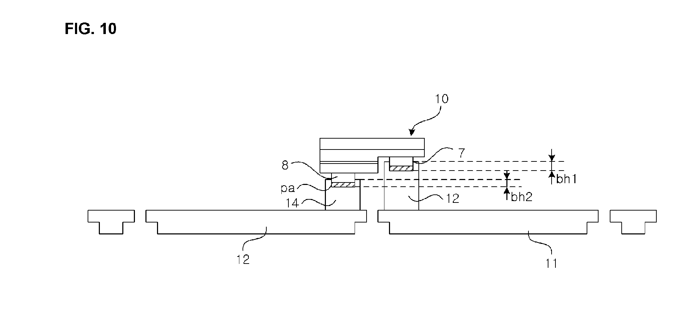

FIG. 9 is a perspective view of a second embodiment of the first and second lead frames of FIG. 6. FIG. 10 is a cross-sectional view illustrating a state in which a light emitting device is disposed on the first and second lead frames of FIG. 9.

In referring to FIG. 9 and FIG. 10, descriptions of the same configurations as in FIG. 7 and FIG. 8 will be eliminated or be briefly addressed.

Referring to FIG. 9 and FIG. 10, the first and second projections 12 and 14 respectively have first and second grooves 12a and 14a formed in the upper portions thereof to receive portions of the first and second electrodes 7 and 8 respectively.

The first and second upper portion widths w1 and w2 of the first and second projections 12 and 14 may respectively be larger than the widths (not labeled) of the first and second electrodes 7 and 8. Ratios of first and second groove widths wh1 and wh2 of the first and second grooves 12a and 14a respectively to the widths (not labeled) of the first and second electrodes 7 and 8 may be in a range of 1 to 1.1, so that the portions of the first and second electrodes 7 and 8 are respectively inserted into the first and second grooves 12a and 14a.

Ratios of first and second depths bh1 and bh2 of the first and second grooves 12a and 14a respectively to thicknesses (not labeled) of the first and second electrodes 7 and 8 may be in a range of 0.3 to 0.7. If the ratios are below 0.3, the portions of the first and second electrodes 7 and 8 may not be securely inserted into the first and second grooves 12a and 14a, respectively. On the other hand, if the ratios are above 0.7, the portions of the first and second electrodes 7 and 8 may be securely inserted into the first and second grooves 12a and 14a respectively, but there may occur cracks at the first and second semiconductor layers 3 and 5 and further the adhesive members may be bonded to the first and second semiconductor layers 3 and 5, leading to reduction of electrical current flow therein.

In accordance with the light emitting device package 100 of this embodiment, when assembling a flip chip type light emitting device 10 on the first and second lead frames 11 and 13, the first and second electrodes 7 and 8 are just bonded to the first and second projections 12 and 14 respectively using the respective adhesive members pa, thereby achieving a simple manufacturing process of the light emitting device package 100.

Moreover, when assembling the light emitting device package 100 of this embodiment, an alignment mark (not shown) used in disposing the light emitting device on the lead frames may be formed on the first and/or second lead frames 11 and 13 and/or the upper surfaces or side surfaces of the first and second projections 12 and 14. A formation position of the alignment mark is not limited thereto.

Furthermore, in accordance with the light emitting device package 100 of this embodiment, it is advantageous that a phosphor may not be contained in the resin material 18 since the light emitting device 10 in the package 100 as shown in FIG. 1 includes the metal ions. Alternatively, when the phosphor is contained in the resin material 18, the amount of the phosphor in the resin material 18 may be advantageously reduced because the metal ions are contained in the second layer 1b of the support member 1 of the light emitting device 10.

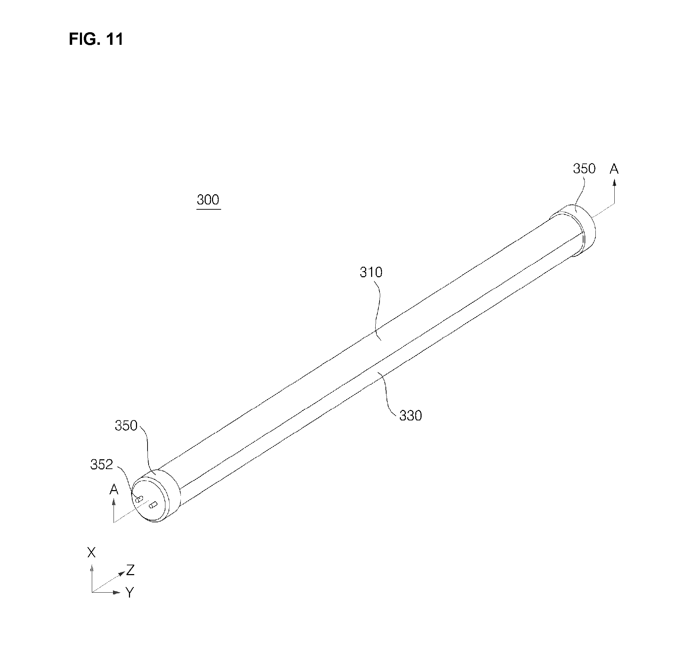

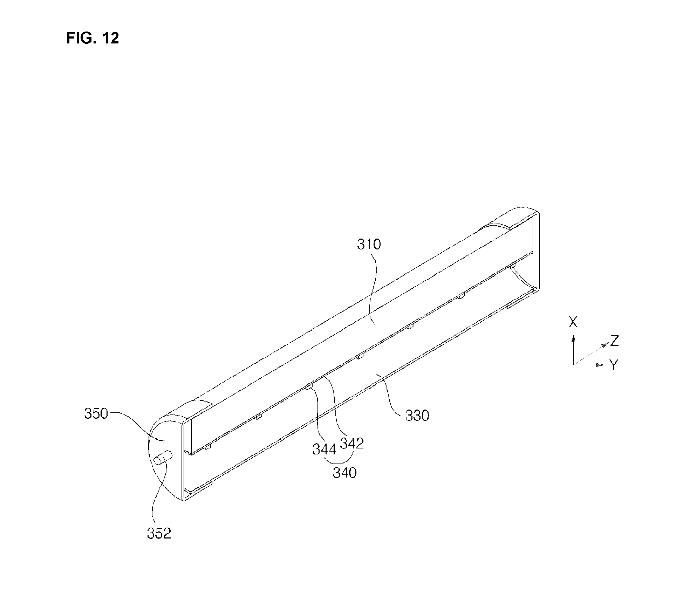

FIG. 11 is a perspective view of an illumination device including the light emitting device according to one embodiment. FIG. 12 is a cross-sectional view taken at a line A-A' of the illumination device of FIG. 11.

Hereinafter, in order to describe the illumination device 300 in a more detailed manner, a length direction Z, a horizontal direction Y perpendicular to the length direction Z and a height direction X perpendicular to a plane formed by the directions Z and Y of the illumination device 300 will be referenced.

FIG. 12 illustrates a cross-section taken according to a plane formed by the directions Z and X and viewed in the horizontal direction Y.

Referring to FIG. 11 and FIG. 12, the illumination device 300 includes a body 310, a cover 330 coupled to the body 310, and finishing caps 350 disposed at both ends of the body 310 respectively.

A light emitting device package array 340 is coupled to the body 310 at a lower face of the body 310. Thus, the body 310 may be made of a metal material having excellent thermal conductivity and heat discharge rate to discharge heat generated from the light emitting device package array 340 from an upper face of the body 310.

The light emitting device package array 340 may include a board 342 and a plurality of the light emitting device packages 344 disposed on the board 342. Each of the light emitting device packages 344 may include a substrate (not shown) and a light emitting device (not shown) disposed on the substrate according to one embodiment.

The light emitting device packages 344 may be arranged on the board 342 in a plural-row or plural-color form to form the light emitting device package array. The light emitting device packages 344 may be spaced from each other by a regular interval or, if necessary, with varying intervals to adjust brightness, etc. of the illumination device 300. The board 342 may be a PCB made of an FR4 material or may be a metal core PCB (MCPCB).

The cover 330 may be formed in a cylindrical shape to encompass the lower face of the body 310, although the present disclosure is not limited thereto.

The cover 330 may protect the light emitting device package array 340 therein from external contaminants, etc.

The cover 330 may contain light diffusion particles to achieve anti-glare effects and/or uniform emission of light generated from the light emitting device package array 340. At least one of the inner and outer surfaces of the cover 330 may be provided with a prism pattern. Also, a phosphor layer may be coated over at least one of the inner and outer surfaces of the cover 330.

Since light generated from the light emitting device package array 340 is outwardly emitted through the cover 330, the cover 330 should have high light transmittance and heat resistance sufficient to endure heat generated from the light emitting device package array 340. To this end, the cover 630 may be made of polyethylene terephthalate (PET), polycarbonate (PC) or polymethylmethacrylate (PMMA).

The finishing caps 350 may be disposed at both ends of the body 310 and function to seal a power supply device (not shown). Each finishing cap 350 is provided with power pins 352, so that the illumination device 300 in accordance with the illustrated embodiment may be directly connected to a terminal, which is provided for a conventional fluorescent lamp, without an additional connector.

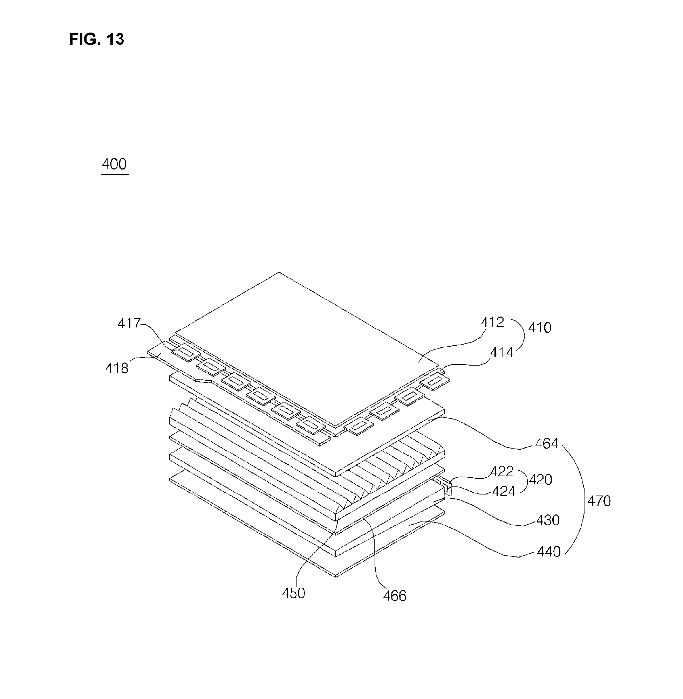

FIG. 13 is a disassembled perspective view of a liquid crystal display device including the light emitting device according to one exemplary embodiment.

FIG. 13 illustrates an edge-light type liquid crystal display device 400. The liquid crystal display device 400 may include a liquid crystal display panel 410 and a backlight unit 470 to supply light to the liquid crystal display panel 410.

The liquid crystal display panel 410 may display an image using the light supplied from the backlight unit 470. The liquid crystal display panel 410 may include a color filter substrate 412 and a thin film transistor substrate 414, which are opposite each other with liquid crystals interposed therebetween.

The color filter substrate 412 may realize the color of an image displayed on the liquid crystal display panel 414.

The thin film transistor substrate 414 is electrically connected to a PCB 418, on which a plurality of circuit elements is mounted, by means of a drive film 417. The thin film transistor substrate 414 may apply drive voltage provided by the PCB 418 to liquid crystals in response to a drive signal transmitted from the PCB 418.

The thin film transistor substrate 414 may include thin film transistors and pixel electrodes in the form of thin films formed on another substrate made of a transparent material such as glass or plastic.

The backlight unit 470 includes a light emitting device package array 420 to emit light, a light guide plate 430 to change light emitted from the light emitting device package array 420 into planar light and to transmit the planar light to the liquid crystal display panel 410, a plurality of films 450, 466 and 464 to achieve brightness uniformity and improved vertical incidence of light emerging from the light guide plate 430, and a reflective sheet 440 to reflect light emitted rearwards from the light guide plate 430 toward the light guide plate 430.

The light emitting device package array 420 may include a plurality of light emitting device packages 424 and a PCB 422 on which the plurality of light emitting device packages 424 is mounted to form an array.

The light emitting device package array 420 may include a board 422 and a plurality of light emitting device packages 424 disposed on the board 442. Each of the light emitting device packages 424 may include a substrate (not shown) and a light emitting device (not shown) disposed on the substrate according to one embodiment.

In this embodiment, the light emitting device may be the light emitting device in FIG. 1. The present disclosure is not limited thereto.

Meanwhile, the backlight unit 470 may include a diffusion film 466 to diffuse light incident thereupon from the light guide plate 430 toward the liquid crystal display panel 410, and a prism film 450 to condense the diffused light so as to enhance vertical light incidence. The backlight unit 470 may further include a protective film 464 to protect the prism film 450.

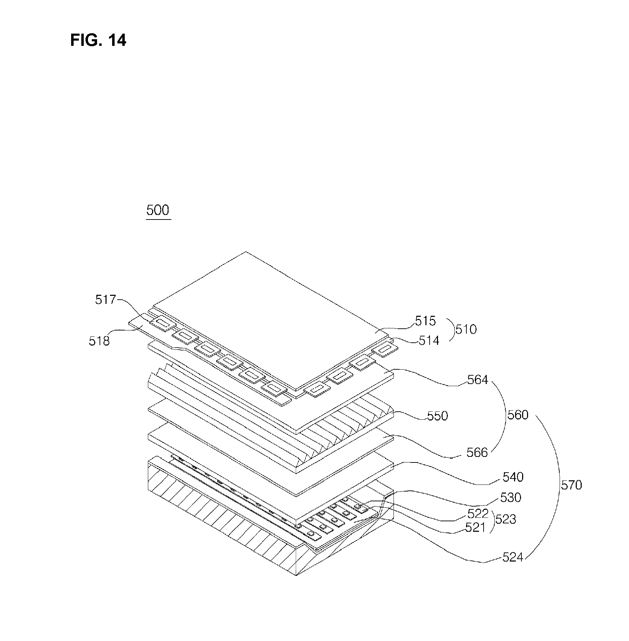

FIG. 14 is a disassembled perspective view of a liquid crystal display device including a light emitting device according to another embodiment.

The same configuration as that illustrated in FIG. 13 and described with reference to FIG. 13 will not be repeatedly described in detail.

FIG. 14 illustrates a direct type liquid crystal display device 500 including a liquid crystal display panel 510 and a backlight unit 570 to supply light to the liquid crystal display panel 510.

The liquid crystal display panel 510 is identical to that of FIG. 13 and, as such, no detailed description thereof will be given.

The backlight unit 570 may include a light emitting device package array 523, a reflective sheet 524, a lower chassis 530 in which the light emitting device package array 523 and reflective sheet 524 are accommodated, and a diffusion sheet 540 and a plurality of optical films 560, which are disposed over the light emitting device package array 523.

The light emitting device package array 523 may include a plurality of light emitting device packages 522, and a PCB 521 on which the plurality of light emitting device packages 522 is mounted to form an array.

In particular, since each light emitting device package 522 may be provided at the light emitting surface thereof with a film made of an electrically conductive material and formed with a plurality of holes, it may be possible to dispense with a lens, and thus to realize a slim light emitting device package structure. Also, it may be possible to enhance light extraction efficiency. Thus, a backlight unit having a thinner structure may be realized.

The reflective sheet 524 reflects light generated by the light emitting device packages 522 toward the liquid crystal display panel 510, to achieve an enhancement in light utilization efficiency.

Meanwhile, the light generated from the light emitting device package array 523 is incident upon the diffusion sheet 540. The optical films 560 are disposed over the diffusion sheet 540. The optical films 560 may include a diffusion film 566, a prism film 550 and a protective film 564.

The illumination device 300 and the display devices 400 and 500 may be included in a lighting system. A lighting device including a light emitting device package may be included in a lighting system.

The light emitting device according to the embodiments includes the metal ions in the support member thereof to convert light of a given wavelength emitted from the light emitting structure and incident upon the support member into light of a wavelength different from the given wavelength. Thus, as for the light emitting device assembled in the light emitting device package, the phosphor may be dispensed with or a very small amount of the phosphor may be used, thereby reducing the manufacturing costs of the light emitting device package.

Particular features, structures, or characteristics described in connection with the embodiment are included in at least one embodiment of the present disclosure and not necessarily in all embodiments. Furthermore, the particular features, structures, or characteristics of any specific embodiment of the present disclosure may be combined in any suitable manner with one or more other embodiments or may be changed by those skilled in the art to which the embodiments pertain. Therefore, it is to be understood that contents associated with such combination or change fall within the spirit and scope of the present disclosure.

Although embodiments have been described with reference to a number of illustrative embodiments thereof, it should be understood that numerous other modifications and applications may be devised by those skilled in the art that will fall within the intrinsic aspects of the embodiments. More particularly, various variations and modifications are possible in concrete constituent elements of the embodiments. In addition, it is to be understood that differences relevant to the variations and modifications fall within the spirit and scope of the present disclosure defined in the appended claims.

## Claims

1. A light emitting device comprising:
a support member; and
a light emitting structure disposed on the support member, the light emitting structure comprising a first semiconductor layer comprises a first and second regions, a second semiconductor layer disposed on the second region, and an active layer between the first and second semiconductor layers,
wherein the support member includes metal ions to convert light of a first wavelength emitted from the active layer into light of a second wavelength different from the first wavelength.

2. The light emitting device of claim 1, wherein the support member comprises a first surface adjacent to the light emitting structure and a second surface opposite the first surface,
wherein the metal ions are disposed on at least one of the first or(and) second surfaces or are injected between the first and second surfaces.

3. The light emitting device of claim 1, wherein the metal ions comprise:
first metal ions to convert light of the first wavelength emitted from the active layer into light of the second wavelength different from the first wavelength; and
second metal ions to convert at least one of light of the first wavelength emitted from the active layer and light of the second wavelength into light of a third wavelength different from the first and second wavelengths.

4. The light emitting device of claim 3, wherein the first and second metal ions are mixed to form a single layer, or respectively form first and second layers stacked one on top of the other.

5. The light emitting device of claim 1 or 2, wherein the metal ions comprise at least one of vanadium ions, chromium ions, titanium ions, or(and) iron ions.

6. The light emitting device of claim 1, wherein the support member comprises aluminum (AI),
wherein a ratio of the metal ions to the aluminum (AI) is in a range of 0.01 % to 0.1 %.

7. The light emitting device of claim 1, further comprising:
a first electrode disposed on the first semiconductor layer; and
a second electrode disposed on the second semiconductor layer.

8. The light emitting device of claim 7, wherein the at least one of the first or(and) second electrodes have formed a single layer or multi-layer.

9. The light emitting device of claim 1, further comprising:
a light-transmissive electrode layer disposed on the second semiconductor layer,
wherein the light-transmissive electrode layer comprises at least one of ITO, IZO(in-ZnO), GZO(Ga-ZnO), AZO(AI-ZnO), AGZO(Al-Ga ZnO), IGZO(ln-Ga ZnO), IrOx, RuOx, RuOx/ITO, Ni/IrOx/Au or(and) Ni/IrOx/Au/ITO.

10. The light emitting device of claim 1, further comprising:
a reflective electrode layer disposed on the second semiconductor layer,
wherein the reflective electrode layer comprises at least one of aluminum (AI), silver (Ag) or(and) copper (Cu).

11. The light emitting device of claim 7, 9 or 10, wherein the second electrode contact with the second semiconductor, light-transmissive or reflective electrode layers.

12. The light emitting device of claim 9 or 10, further comprising:
a wavelength conversion layer disposed on the second semiconductor, the light-transmissive electrode layer or between the reflective electrode layer and the second semiconductor layer.

13. The light emitting device of claim 12, wherein the wavelength conversion layer comprises a phosphor.

14. The light emitting device of claim 1, wherein the active layer comprises at least one well layer and barrier layer having different energy band gaps; and
an energy band gab of the well layer or barrier layer adjacent to the second semiconductor layer has is larger than an energy band gap of the well layer or barrier layer adjacent to the first semiconductor layer.

15. A lighting system comprising the light emitting device of any one of claims 1 to 14.
